Europäisches Patentamt

European Patent Office

Office européen des brevets

(11) Numéro de publication: **0 403 365**
**A1**

# DEMANDE DE BREVET EUROPEEN

(21) Numéro de dépôt: **90401615.1**

(51) Int. Cl.5: **H01L 47/02**

(22) Date de dépôt: **12.06.90**

(30) Priorité: **13.06.89 FR 8907783**

(43) Date de publication de la demande:
**19.12.90 Bulletin 90/51**

(84) Etats contractants désignés:
**DE FR GB**

(71) Demandeur: **THOMSON-CSF**
**51, Esplanade du Général de Gaulle**
**F-92800 Puteaux(FR)**

(72) Inventeur: **Delage, Sylvain**
**Thomson-CSF, SCPI, Cédex 67**
**F-92045 Paris La Défense(FR)**
Inventeur: **Brylinsky, Christian**
**Thomson-CSF, SCPI, Cédex 67**
**F-92045 Paris La Défense(FR)**

(74) Mandataire: **Ruellan-Lemonnier, Brigitte et al**
**THOMSON-CSF SCPI**
**F-92045 PARIS LA DEFENSE CEDEX 67(FR)**

(54) Composant à effet Gunn comportant un dispositif d'injection d'électrons.

(57) La présente invention concerne un composant à effet Gunn comportant un dispositif d'injection d'électrons ainsi qu'un procédé de réalisation d'un tel composant.

Conformément à l'invention, le dispositif d'injection d'électrons est constitué par au moins un transistor (2) ou dipôle limiteur de courant éventuellement programmable à structure verticale en série au composant (1), l'ensemble formant une structure intégrée.

FIG_1

EP 0 403 365 A1

## COMPOSANT A EFFET GUNN COMPORTANT UN DISPOSITIF D'INJECTION D'ELECTRONS

La présente invention concerne un composant à effet Gunn et plus particulièrement un composant à effet Gunn comportant un dispositif d'injection d'électrons.

Les composants à effet Gunn présentent l'avantage de donner de très bons oscillateurs locaux avec une très bonne pureté spectrale entre 10 et 100 GHz. Toutefois, le rendement de ce type de composants est encore très faible, en général inférieur à 5% à 94 GHz, ce qui limite la puissance disponible et conduit à des températures de fonctionnement des composants de l'ordre de 250° C. Ce rendement est en général pénalisé par l'injection non-optimale des électrons dans la couche active de la structure. En effet, l'injection par une couche N + telle qu'elle est pratiquée actuellement, conduit d'une part à des densités de courant de deux à trois fois supérieures à la densité optimale et d'autre part à un profil de champ électrique inhomogène dans l'épaisseur de la couche active de la diode. De plus, on observe de fortes déperditions énergétiques par collisions au cours de la phase d'accélération des électrons qui participent à l'effet Gunn. Or, l'augmentation du rendement des composants à effet Gunn est cruciale pour leur industrialisation. En effet, toute augmentation de rendement permet soit d'augmenter la puissance disponible, soit d'augmenter la durée de vie des composants grâce notamment à la diminution des températures de fonctionnement.

On a proposé jusqu'ici plusieurs moyens qui permettent d'améliorer l'injection des électrons en limitant la densité du courant et/ou en permettant une pré-accélération des électrons avant injection. Ainsi, on a proposé que le contact cathode - zone active d'un composant à effet Gunn soit constitué d'une barrière de potentiel polarisée en inverse. Ce type de contact est appelé contact limitant, car la barrière de potentiel polarisée en inverse déserte la zone active et limite le courant dans la diode. Plusieurs types de contact limitant peuvent être envisagés. Selon un premier mode de réalisation, le contact limitant peut être constitué par une jonction métallique à faible hauteur de barrière. Selon un second mode de réalisation, ce contact limitant peut être constitué par une hétéro-jonction entre deux semiconducteurs, la discontinuité entre les bandes de conduction jouant le rôle de barrière de potentiel. Dans le premier cas, on a obtenu des rendements supérieurs à - 4% et une puissance moyenne de 70mW à 94 GHz sur certaines structures. Toutefois, ce type de contact présente un certain nombre d'inconvénients, notamment en ce qui concerne la reproductibilité des caractéristiques des composants à effet Gunn.

La présente invention a pour but de remédier à ces inconvénients en proposant un composant à effet Gunn comportant un dispositif d'injection d'électrons qui soit facilement industrialisable et dont les caractéristiques soient reproductibles d'un composant à l'autre.

En conséquence, la présente invention a pour objet un composant à effet Gunn comportant un dispositif d'injection d'électrons, caractérisé en ce que le dispositif d'injection d'électrons est constitué par au moins un transistor ou dipôle limiteur de courant éventuellement programmable à structure verticale connecté en série au composant, l'ensemble formant une structure intégrée.

Selon un mode de réalisation préférentiel, le transistor ou dipôle limiteur de courant éventuellement programmable à structure verticale est à base perméable. Il est de préférence monté en dipôle non programmable.

D'autre part, plusieurs centaines de transistors ou de dipôles en parallèle sont intégrés dans le dispositif d'injection de manière à obtenir une amélioration notable de l'injection des électrons.

La présente invention concerne aussi un procédé de fabrication d'un composant à effet Gunn comportant un dispositif d'injection d'électrons, caractérisé par les étapes suivantes :
- après avoir réalisé de manière connue sur un substrat en un matériau semiconducteur une structure semiconductrice active susceptible de présenter l'effet Gunn, on réalise, sur la face opposée au substrat, un masque en résine constitué d'un réseau régulier de plots ;
- on dépose sur le masque de résine une première couche métallique puis on élimine la résine de manière obtenir sur la structure semiconductrice une grille métallique ;
- en utilisant la grille métallique comme masque, on grave des ouvertures dans la structure semiconductrice, on dépose de manière uniforme sur la grille métallique et les ouvertures précédemment pratiquées, une seconde couche métallique permettant d'obtenir, éventuellement après un recuit, au fond des ouvertures et/ou sur les flancs de ces ouvertures, une barrière métal/semiconducteur ou une jonction P-N ;
- on dépose alors de manière connue sur la seconde couche métallique, un matériau ayant un bon coefficient de conductivité thermique (ce matériau est de préférence constitué par de l'or) ;
- puis de manière connue, après avoir aminci le substrat, on réalise un contact métallique sur la surface côté substrat par dépôt d'une troisième couche métallique et recuit.

Lors du dépôt de la seconde couche métallique ou lors d'un recuit, il y a création, au fond des ouvertures, d'une barrière de potentiel répulsive pour les électrons. On a donc réalisé ce stade une structure base perméable.

D'autre part, la seconde couche métallique réalise un court circuit entre la grille métallique qui forme la cathode de la structure base perméable et les éléments de la seconde couche métallique qui constituent, au fond et/ou sur les flancs des ouvertures, la grille de la structure base perméable. La composant réalisé se présente donc comme un dipôle non programmable.

D'autres caractéristiques et avantages de la présente invention apparaîtront à la lecture de la description faite ci-après d'un mode de réalisation préférentiel dans lesquels :

- la figure 1 est un schéma électrique simplifié d'une diode à effet Gunn munie d'un dispositif d'injection conforme à la présente invention ;

- les figures 2a à 2e représentent schématiquement une vue en coupe des différentes étapes de réalisation d'une diode Gunn munie d'un dispositif d'injection conforme à la présente invention.

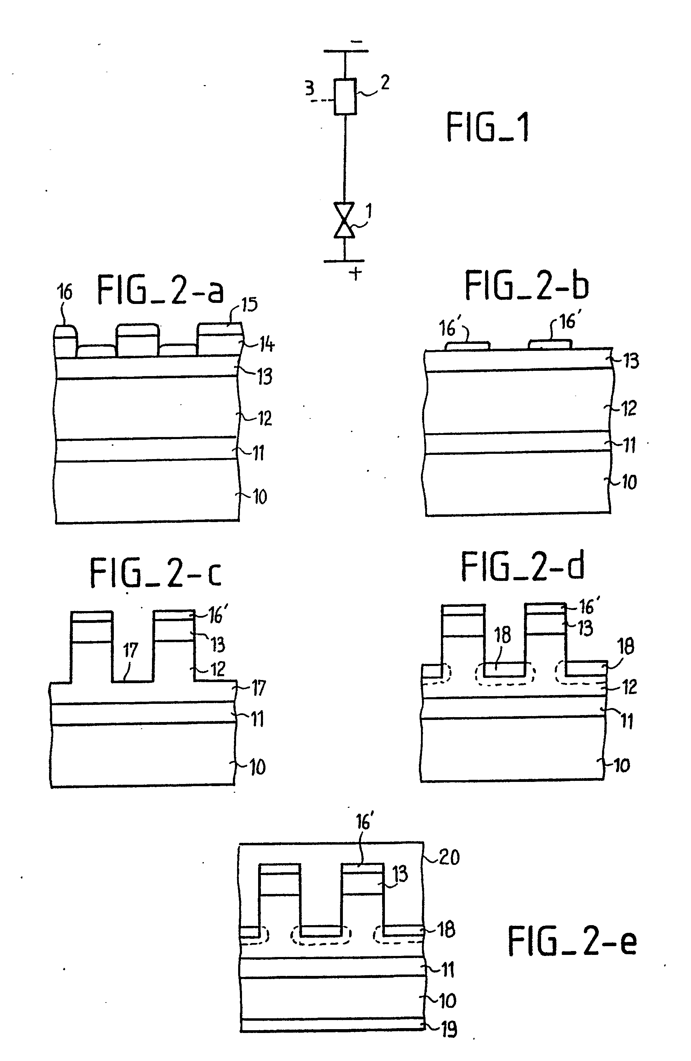

Comme représenté sur la figure 1, le dispositif d'injection conforme à la présente invention est constitué par un transistor ou dipôle limiteur de. courant éventuellement programmable 2 connecté en série à la cathode d'une diode Gunn 1 dont l'anode est connectée à la borne + d'un circuit, l'autre borne du dipôle étant reliée à la borne - du circuit. Comme représenté sur la figure 1, le dipôle comporte éventuellement une électrode 3 permettant sa programmation. Par translstor ou dipôle limiteur de courant éventuellement programmable, on entend aussi bien des composants à deux électrodes que des composants à trois électrodes. Dans le cas des composants à trois électrodes, la troisième électrode est soit connectée à une des autres électrodes pour former un composant dipôlaire, soit utilisée comme électrode de programmation. Dans ce cas, le rôle de l'électrode de programmation se distingue de celui d'une grille ou base d'un transistor par le fait que la fréquence de coupure de la réponse du signal de sortie du composant au signal de programmation est largement inférieure (un ou plusieurs ordres de grandeurs) à la fréquence des signaux de courant et de tension qui traversent le composant en fonctionnement normal.

On décrira maintenant de manière plus détaillée avec référence aux figures 2a à 2b, un procédé de réalisation d'une diode Gunn munie d'un dispositif d'injection d'électrons conforme à la présente invention. La matériau utilisé dans le mode de réalisation décrit ci-après est du phosphure d'indium InP. Toutefois, il est évident pour l'homme de l'art que tout matériau semiconducteur présentant un effet Gunn peut être utilisé, à savoir entre autres des composés III-V de la classification périodique des éléments tels que l'arseniure de gallium GaAs et le phosphure d'indium InP ainsi que des alliages II-VI. Comme représenté sur la figure 2a, on a réalisé sur un substrat d'InP 10, une structure active en InP. Cette structure est obtenue par exemple par épitaxie en phase vapeur et elle est constituée dans le mode de réalisation représenté, d'une couche-tampon 11 d'InP dopé N+ d'une couche active 12 d'InP dopé N et d'une couche de contact 13 d'InP dopé N+. Il est évident pour l'homme de l'art que d'autre types de structure pourraient être utilisés sans sortir du cadre de la présente invention. Ainsi, la couche de contact pourrait être réalisée en Ga In As. De même, une couche d'arrêt réalisée par exemple en Ga In As pourrait être interposée entre la couche-tampon 11 et le substrat 10. Ces différentes couches concernent les modes de réalisation d'une diode Gunn qui sont bien connus de l'homme de l'art. D'autre part, le dopant utilisé pour le phosphure d'indium est, dans le mode de réalisation, constitué par du silicium, mais pourrait être Sn, Ge, S, Se, Te.

Conformément à la présente invention, sur la couche de contact 13, on réalise de manière connue un masque 14 présentant une mosaïque de plots séparés par des tranchées dont le réseau constitue une grille 15. Ce masque est réalisé par exemple, à l'aide de deux couches de résine telles que PMM et AZ. Sur ce masque, l'on dépose une couche métallique 16 plus particulièrement une couche 16 réalisée par dépôt successif de métaux tels que l'or-germanium, le titane, le platine et l'or, les couches de platine et de titane jouant le rôle de barrière de diffusion. Ensuite, on élimine de manière connue le masque 14 et les couches métalliques 16 déposées sur ce masque de manière à ne dégager que la grille métallique 16' correspondant aux tranchées, comme représenté sur la figure 2b. Puis en utilisant la grille métallique 16' comme masque, on grave des ouvertures 17 dans la structure semiconductrice. Ces ouvertures 17 sont réalisées, de préférence, par gravure ionique dans la couche de contact 13 et dans une partie de la couche active 12 (voir figure 2c). On dépose alors sur la grille métallique 16' et les ouvertures 17 une seconde couche métallique 18 constituée d'un alliage dont un des composants est une impureté acceptrice pour le matériau semiconducteur, comme représenté sur la figure 2d. Dans le mode de réalisation, il s'agit d'un alliage or-zinc. En effet, le zinc est un accepteur pour le phosphure d'indium et il diffuse donc dans la couche active 12 entourant la couche métallique 18 de manière à créer une jonction P-N, comme représenté par les tirets sur la figure 2d. La charge d'espace créée dans ce cas ne s'étend pas sur toute la profondeur de la couche active. Eventuellement, à ce stade l'ensemble peut être soumis à un recuit. Puis après avoir préparé la face opposée du substrat 10 de manière connue, à savoir après avoir aminci le substrat, on dépose sur cette face une troisième couche métallique 19 de manière à réaliser un contact métallique. De préférence, cette troisième couche métallique est constituée par dépôt successif d'or-germanium, de titane, de platine et d'or. On a ainsi réalisé une diode Gunn dans l'anode d'une structure verticale à effet de champ ou à base perméable. D'autre part, selon un mode de réalisation préférentiel, on fait croître sur les plots 16 et les couches déposées dans les ouvertures 18, un métal ayant un bon coefficient de conductivité thermique tel que de l'or électrolytique, de manière à réaliser un radiateur. Cet or réalise une connexion entre les plots 16′ constituant les émetteurs, sources ou cathodes des injecteurs verticaux et les grilles 18 de manière à former un dipôle. Ce montage en dipôle facilite l'utilisation des composants Gunn par les équipementiers.

Dans la mise en oeuvre ci-dessus, on réalise en pratique sur la diode Gunn une mosaïque d'injecteurs verticaux constituée en pratique de plusieurs centaines d'injecteurs verticaux à effet de champ ou à base perméable. En fait, la largeur des ouvertures 18 est calculée en fonction du dopage du semiconducteur et de la hauteur de la barrière de potentiel que l'on souhaite obtenir. Un calcul rapide montre que, pour une hauteur de barrière de 0,4 eV (typique d'une barrière métal/InP) et un niveau de dopage de $5 \times 10^{14}$ cm$^{-3}$, un espacement de 2 um serait adéquate. De telles dimensions peuvent être aisément obtenues car elles sont compatibles avec la lithographie optique utilisée en général pour réaliser ce type de composant.

D'autre part, on sait que, dans un transistor à base perméable, il existe un fort champ électrique près de la grille métallique. Ceci permet donc d'accélérer substantiellement les électrons et, en rapprochant les doigts métalliques, d'améliorer encore la vitesse initiale des porteurs. On obtient donc un dispositif d'injection des électrons améliorant le rendement de conversion des composants à effet Gunn. Ainisi, dans la présente invention, le rôle du dispositif d'injection est d'accélérer la formation de domaines en synthétisant un profil de champ électrique optimal à la cathode du dispositif et en limitant la densité du courant injecté. La structure que propose l'invention permet aussi la propagation simultanée de plusieurs domaines dipôlaires dans la couche active du composant à effet Gunn.

**Revendications**

1. Composant à effet Gunn comportant un dispositif d'injection d'électrons, caractérisé en ce que le dispositif d'injection d'électrons est constitué par au moins un translstor (2) ou dipôle limiteur de courant éventuellement programmable à structure verticale connecté en série au composant (1), l'ensemble formant une structure intégrée.

2. Composant à effet Gunn selon la revendication 1, caractérisé en ce que le transistor ou dipôle limiteur de courant éventuellement programmable à structure verticale est à base perméable.

3. Composant à effet Gunn selon la revendication 2, caractérisé en ce que le transistor ou dipôle limiteur de courant éventuellement programmable à base perméable est un dipôle limiteur de courant non programmable à base perméable.

4. Composant à effet Gunn selon l'une quelconque des revendications 1 à 3, caractérisé en ce que le transistor ou dipôle limiteur de courant éventuellement programmable à structure verticale est formé de plusieurs transistors ou dipôles en parallèle.

5. Composant à effet Gunn selon la revendication 4, caractérisé en ce que le transistor ou dipôle limiteur de courant éventuellement programmable à structure verticale est formé de plusieurs centaines de transistors ou dipôles en parallèle.

6. Procédé de fabrication d'un composant à effet Gunn comportant un dispositif d'injection d'électrons selon l'une quelconque des revendications 1 à 5, caractérisé par les étapes suivantes :
- après avoir réalisé de manière connue sur un substrat (10) en un matériau semiconducteur une structure semiconductrice active (11, 12, 13) susceptible de présenter l'effet Gunn, on réalise sur la face opposée au substrat, un masque en résine (14) constitué d'un réseau régulier de plots ;
- on dépose sur le masque de résine une première couche métallique (16, 16′) puis on élimine la résine de manière à obtenir sur la structure semiconductrice une grille métallique (16′) ;
- en utilisant la grille métallique comme masque, on grave des ouvertures (17) dans la structure semiconductrice ;
- on dépose de manière uniforme sur la grille métallique et les ouvertures précédemment pratiquées, une seconde couche métallique (18) permettant d'obtenir au fond des ouvertures et/ou sur les flancs de ces ouvertures, une barrière métal/semiconducteur ou une fonction P-N, la charge d'espace créée à ce niveau présentant une profondeur inférieure à l'épaisseur de la couche active ;
- on dépose alors de manière connue sur la seconde couche métallique (18) un matériau ayant un bon coefficient de conductivité thermique ;
- puis de manière connue après avoir aminci le substrat, on réalise un contact métallique (19) sur la face côté substrat par dépôt d'une troisième couche métallique et recuit.

7. Procédé selon la revendication 6, caractérisé en ce que le matériau semiconducteur est constitué par les composés III-V et les alliages II-VI de la classification périodique des éléments.

8. Procédé selon les revendications 6 et 7, caractérisé en ce que la structure semiconductrice active est constituée par une structure (11, 12, 13) N+/N/N+ réalisée par épitaxie.

9. Procédé selon la revendication 6, caractérisé en ce que les première et troisième (16, 164, 19) couches métalliques sont réalisées par dépôts successifs d'or-germanium, de titane, de platine et d'or.

10. Procédé selon la revendication 8, caractérisé en ce que les dépôts sont réalisés par évaporation.

11. Procédé selon la revendication 6, caractérisé en ce que la seconde couche métallique (18) est constituée par un alliage or-zinc.

12. Procédé selon la revendication 6, caractérisé en ce que le matériau ayant un bon coefficient de dissipation est constitué par de l'or.

FIG_1

FIG_2-a

FIG_2-b

FIG_2-c

FIG_2-d

FIG_2-e

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | FR-A-2293069 (THOMSON CSF)<br>* le document en entier *<br>--- | 1-12 | H01L47/02 |
| A | US-A-4495511 (M.N. YODER)<br>----- | | |

| | |
|---|---|
| | DOMAINES TECHNIQUES RECHERCHES (Int. Cl.5) |
| | H01L |

Le présent rapport a été établi pour toutes les revendications

| Lieu de la recherche | Date d'achèvement de la recherche | Examinateur |
|---|---|---|
| LA HAYE | 17 SEPTEMBRE 1990 | PELSERS L. |